# EUROPÄISCHE PATENTSCHRIFT

(11) **EP 1 264 000 B1**
(45) Veröffentlichungstag und Bekanntmachung des Hinweises auf die Patenterteilung: **25.06.2008**
(21) Anmeldenummer: 01936062.7
(22) Anmeldetag: 08.03.2001
(51) Int. Cl.: C23C 14/00, C23C 14/16

(54) **VERFAHREN ZUR ABSCHEIDUNG VON AMORPHEN, WASSERSTOFFHALTIGEN SILIZIUMSCHICHTEN**
METHOD FOR DEPOSITING AMORPHOUS SILICON LAYERS THAT CONTAIN HYDROGEN
PROCEDE POUR DEPOSER DES COUCHES DE SILICIUM AMORPHES CONTENANT DE L'HYDROGENE

(30) Priorität: 10.03.2000 DE 10011857
(43) Veröffentlichungstag der Anmeldung: 11.12.2002
(73) Patentinhaber: Fraunhofer-Gesellschaft zur Förderung der angewandten Forschung e.V., 80686 München (DE)
(72) Erfinder: SZYSZKA, Bernd Dr, 38176 Wendeburg (DE); KLAGES, Claus-Peter, 38102 Braunschweig (DE); JIANG, Xin, 38108 Braunschweig (DE); JUNG, Thomas, 38173 Hötzum (DE)
(74) Vertreter: Pfenning, Meinig & Partner GbR
(86) Internationale Anmeldenummer: PCT/EP2001/002599
(87) Internationale Veröffentlichungsnummer: WO 2001/066815

(56) Entgegenhaltungen:
- DE-A- 4 235 953
- PATENT ABSTRACTS OF JAPAN vol. 012, no. 438 (C-544), 17. November 1988 (1988-11-17) & JP 63 162875 A (TDK CORP), 6. Juli 1988 (1988-07-06)
- MARAKHONOV V ET AL: "Electrical and optical properties of a-Si:H, a-SiGe:H and a-SiSn:H deposited by magnetron assisted silane decomposition" 14TH INTERNATIONAL CONFERENCE ON AMORPHOUS SEMICONDUCTORS - SCIENCE AND TECHNOLOGY. ICAS 14, GARMISCH-PARTENKIRCHEN, GERMANY, 19-23 AUG. 1991, Bd. 137-138, pt.2, Seiten 817-820, XP002174715 Journal of Non-Crystalline Solids, Dec. 1991, Netherlands ISSN: 0022-3093

## Beschreibung

Die vorliegende Erfindung bezieht sich auf ein Verfahren zur Beschichtung eines Substrates mit amorphen, wasserstoffhaltigen Siliziumschichten. Derartige Siliziumschichten werden insbesondere im Bereich der Solarzellen verwendet.

Für die Herstellung von amorphen, wasserstoffhaltigen Siliziumschichten, sogenannten a-Si:H-Schichten, sind verschiedene Verfahren bekannt, die entweder von einer flüchtigen Siliziumverbindung ausgehen oder von festem Silizium [1]. Wird von flüchtigen Siliziumverbindungen wie beispielsweise Silan SiH₄ oder Disilan Si₂H₆ ausgegangen, die durch ein Plasma, durch Photonen oder heiße Drähte aktiviert sind, so spricht man von CVD-Verfahren (Chemical Vapour Deposition-Verfahren). Wird von festem Silizium ausgegangen, so eignen sich hierzu sogenannte PVD-Verfahren (Physical Vapour Deposition), wie beispielsweise reaktives Sputtern. Die erzielbaren strukturellen und elektronischen Eigenschaften der a-Si:H-Schichten hängen dabei stark von den Herstellungsbedingungen ab, da es sich bei a-Si:H um ein metastabiles Material handelt.

So weisen amorphe, wasserstoffhaltige Siliziumschichten, die durch reaktives Sputtern, wie beispielsweise durch Hochfrequenzsputtern hergestellt wurden, im allgemeinen eine höhere Konzentration an Defekten und schlechtere photoelektrische Eigenschaften auf als Schichten, die durch plasmaaktivierte CVD-Abscheidung (PACVD) gewonnen wurden. Dies wurde beispielsweise anhand des Beweglichkeit-Lebensdauer-Produkts der Minoritäts- und Majoritätsladungsträger für gesputterte bzw. durch plasmaaktivierte Abscheidung gewonnene Schichten nachgewiesen.

Lediglich bei Verwendung sogenannter Triodenanordnungen, die auf einer Trennung von Plasmaerzeugung und Sputterprozeß basieren, wurden bessere Schichteigenschaften erreicht. Für das Erzielen hochwertiger Schichteigenschaften ist ein derartiges Verfahren jedoch auf geringe Leistungsdichten am Target beschränkt, so daß geringe Depositionsraten lediglich im Bereich von 1 Å/s resultieren.

Auch für die etablierten PACVD-Prozesse zur Abscheidung amorpher, wasserstoffhaltiger Siliziumschichten ist bekannt, daß hohe Leistungsdichten zu einer unvorteilhaften Dissoziation des Reaktivgases SiH₄ führen. Unter solchen Bedingungen hergestellte Proben weisen einen hohen SiH₂-Anteil auf, der die optoelektronischen Eigenschaften der Schichten beeinträchtigt und der anhand der Absorptionsbande im IR-Spektrum bei k ≈ 2100 cm⁻¹ identifiziert werden kann.

Für die Herstellung von Solarzellen, einer der wesentlichen Anwendungsbereiche für amorphe, wasserstoffhaltige Siliziumschichten, wird heute überwiegend Hochfrequenz-PACVD eingesetzt. Es gibt jedoch schwerwiegende Nachteile bei diesem Verfahren. Erstens beträgt die bislang erzielte Abscheiderate für Schichten guter Qualität nur 0,3 - 0,5 nm/s, was hohe Herstellungskosten verursacht. Ein zweiter Nachteil de Verfahrens besteht darin, daß es extra flüchtige und in den meisten Fällen sehr giftige Quellen wie Diboran oder Phosphin benötigt, um p- oder n-dotierte Schichten für den Aufbau von Solarzellen herzustellen. Ein dritter Nachteil ist, daß es nicht kompatibel mit einem in-line-Verfahren ist, wie es beispielsweise für die Herstellung der transparenten leitfähigen Elektrode üblich ist. Die a-Si:H-Abscheidung findet daher gewöhnlich in einem separaten Batch-Prozess statt.

Aufgabe der vorliegenden Erfindung ist es daher, ein Verfahren zur Beschichtung von Substraten mit amorphen, wasserstoffhaltigen Siliziumschichten anzugeben, das die obigen Nachteile vermeidet und gute a-Si:H-Schichten in einem in-line-Verfahren ermöglicht.

Diese Aufgabe wird durch das Verfahren nach Anspruch 1 und die Verwendung nach Anspruch 17 gelöst. Vorteilhafte Weiterbildungen des erfindungsgemäßen Verfahrens finden sich in den abhängigen Ansprüchen.

Erfindungsgemäß wird bei dem vorgeschlagenen Verfahren ein Sputtergas und ein Reaktivgas in eine Gasfluß-Sputterquelle eingeleitet. Die Gasfluß-Sputterquelle weist ein Target auf, das Silizium enthält. Das Target kann gegebenenfalls dotiert sein, beispielsweise mit Bor oder Phosphor.

Die in der Sputterquelle erzeugten Ionen sputtern nun das Target und bewirken gleichzeitig eine Plasmazersetzung und Gasphasenaktivierung des Reaktivgases. Dieser Gasfluß durchströmt nun die Gasfluß-Sputterquelle und thermalisiert nach ihrem Verlassen noch bevor er auf das Substrat trifft.

Zwischen der Gasfluß-Sputterquelle und dem Substrat kann weiteres Reaktivgas eingeleitet werden.

Überraschenderweise wurde festgestellt, daß die Schichteigenschaften der amorphen, wasserstoffhaltigen Siliziumschichten erheblich besser sind, wenn eine kombinierte Sputter-/PACVD-Deposition mit Hohlkathoden-Quellen zum reaktiven Sputtern von Silizium und zur Plasmazersetzung z.B. in einer Ar/H₂/SiH₄-Atmosphäre verwendet wird. Dies betrifft insbesondere die Eigenschaften bezüglich eines größeren τc-Gaps, eines größeren µ x τ-Produktes und eines größeren Verhältnisses der Hell- und Dunkelleitfähigkeiten. Im Vergleich mit gewöhnlicher PECVD ist die Abscheiderate deutlich höher (> 1 nm/s) und es ist möglich, die in situ-Dotierung der Schichten über Gasflußsputtern eines dotierten Si-Targets zu realisieren. Unter prozeßökonomischen Gesichtspunkten ist es also außerordentlich interessant, a-Si:H mit guter Qualität durch ein kombiniertes Verfahren aus Plasma-CVD und Sputter-Prozeß abzuscheiden, da ein derartiges kombiniertes Verfahren sowohl eine hohe Wachstumsrate ermöglicht als auch die giftigen Quellen für die Dotierung erübrigt.

Erfindungsgemäß wurde daher erkannt, daß die Nachteile der PVD-Verfahren und der CVD-Verfahren zur Herstellung amorpher, wasserstoffhaltiger Siliziumschichten vermieden werden können, wenn die Schicht zum großen Teil durch Plasmazersetzung mittels Hohlkathoden-Entladung abgeschieden wird. Für die Plasmazersetzung zur Abscheidung von a-Si:H wird die Hohlkathoden-Entladung, die sonst für das Gasflußsputtern genutzt wird, zur Erzeugung von Plasma verwendet. Das heißt, die Hohlkathode dient als Ionenquelle für die Plasmazersetzung. Vorteilhafterweise entstehen hierbei überwiegend SiH₃-Radikale statt SiH₂ wie im Stand der Technik. Beim Gasflußsputtern handelt es sich um ein Verfahren, wie es durch einen besonderen Transport der von der Targetoberfläche abgesputterten Atome oder wie in der vorliegenden Erfindung, durch Plasma aktivierten Gasspezies gekennzeichnet ist. Hierzu kann eine Hohlkathoden-Sputteranlage verwendet werden. Die Hohlkathoden-Sputteranlage weist eine Hohlkathode aus Targetmaterial auf. Die abgesputterten Atome oder die aktivierten Gasspezies thermalisieren daher innerhalb der Hohlkathode und werden durch einen Gasstrom, beispielsweise einen Inertgasstrom oder wie in der vorliegenden Erfindung, einen gemischten Inertgas/Reaktivgasstrom aus der Hohlkathode herausgetragen und auf ein davor befindliches Substrat abgeschieden. Aufgrund dieses konvektiven Transports der abgesputterten Atome und des relativ hohen Arbeitsdruckes, üblicherweise > 10 Pa, während Sputterprozesse sonst bei ≤ 1 Pa ablaufen, können andere Schichteigenschaften erhalten werden als bei üblichen Sputterprozessen. So findet beispielsweise praktisch kein Bombardement der Schicht mit energetischen, vom Target reflektierten Neutralteilchen statt.

Im vorliegenden Fall, wo Silizium in einem Gemisch von Argon und gegebenenfalls Wasserstoff gesputtert wird, ist auch mit der Reaktion von Siliziumatomen mit Wasserstoffatomen zu Radikalen SiHₙ (n = 1.....3) zu rechnen. Das Gasflußsputtern ist genauer in der Druckschrift DE 42 35 953 A1 beschrieben, die von der vorliegenden Anmelderin eingereicht wurde.

Um einen DC-Sputterprozess für die Dotierung zu erlauben, kann das Targetmaterial eine gewisse Leitfähigkeit besitzen; eine spezifische Leitfähigkeit > 0,1 S/cm ist im allgemeinen ausreichend. Daraus folgt, daß bereits eine sehr geringe Dotierung des Siliziums mit Bor (10¹⁵ cm⁻³) oder Phosphor (4 x 10¹⁴ cm⁻³) ausreicht, um das Material bei Raumtemperatur (300 K) genügend leitfähig zu machen. Insbesondere für die Bordotierung gilt, daß Konzentrationen in dieser Größenordnung im a-Si:H sich praktisch noch nicht auf die Löcherbeweglichkeit auswirken [4]. Für die Abscheidung der P- oder n-dotierten Schichten werden in den meisten Fällen Si-Targets mit höheren Bor- oder Phosphorgehalten dotiert. Bei Verwendung eines dotierten Targets wird der Einsatz von giftigen Dotierstoff-Precursorn wie beispielsweise Diboran oder Phosphin vermieden. Alternativ kann eine Heizung des Targets, vorteilhafterweise auf ca. 250 bis 300 °C vorgesehen sein, um durch thermische Aktivierung auch intrinsisches Silizium genügend leitfähig zu machen.

Die im nachfolgenden Ausführungsbeispiel beschriebenen Ergebnisse zeigen, daß das kombinierte PECVD/Gas flußsputter-Verfahren zur Herstellung von hochwertigen a-Si:H-Schichtsystemen für optoelektronische Anwendungen geeignet ist. Die erfindungsgemäß hergestellten a-Si:H-Schichtsysteme weisen im Vergleich zu konventionell hergestellten Proben überlegene elektrische Eigenschaften auf. Maßgeblich dafür sind die speziellen Charakteristika des kombinierten Prozesses. Das Verfahren kann als Remote-Plasmadepositionsprozess aufgefaßt werden, so daß die in konventionellen Sputterprozessen unvermeidliche Schädigung der aufwachsenden Schicht durch energetische Spezies unterdrückt wird. Gleichermaßen bleibt ein intensives, niederenergetisches Ionenbombardement der aufwachsenden Schicht aufgrund der hohen Plasmadichte des GFS-Prozesses erhalten, so daß das Wachstum hochdichter, gut vernetzter a-Si:H-Schichten begünstigt wird. Die Teilchen-Energie läßt sich auch durch das Anlegen einer Substratbiasspannung einstellen.

Auch ein SiH₂-Einbau, wie er aus den PACVD-Prozessen aus dem Stand der Technik bekannt ist, wird bei den erfindungsgemäßen Verfahren nicht beobachtet. Damit überwindet das erfindungsgemäße Verfahren auch die bisher problematische Begrenzung der Leistungsdichte und damit der Depositionsrate bei der Herstellung von a-Si:H-Schichtsystemen.

Im folgenden werden Beispiele des erfindungsgemäßen Verfahrens gegeben.

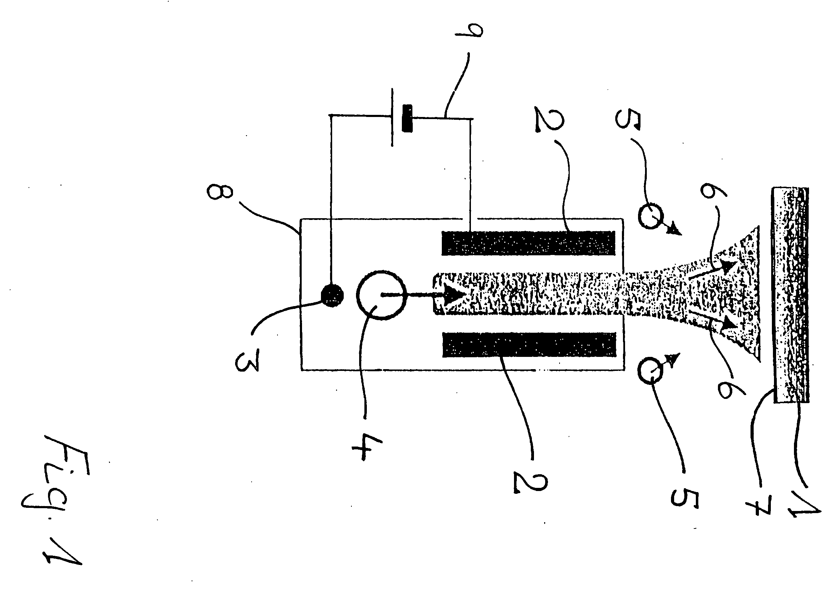

Figur 1 zeigt schematisch die Beschichtung mittels des erfindungsgemäßen Verfahrens. Dabei wird mittels einer Gasfluß-Sputterquelle 8 ein Substrat 1 beschichtet. Das Substrat 1 erhält durch die Beschichtung auf seiner der Sputterquelle 8 zugewandten Seite eine amorphe, wasserstoffhaltige Siliziumschicht 7.

Die Gasfluß-Sputterquelle selbst besteht aus einer Hohlkathode 2 aus Targetmaterial, beispielsweise Silizium bzw. bor- oder phosphordotiertes Silizium. Weiterhin ist in der Gasfluß-Sputterquelle 8 eine Anode 3 angeordnet, die über eine Spannungsversorgung elektrisch mit der Kathode 2 verbunden ist. Die Spannungsversorgung 9 ist eine Gleichstrom-Leistungsversorgung (DC-Leistungsversorgung). Weiterhin enthält die Gasfluß-Sputterquelle 8 einen Einlaß 4 für die Reaktivgase, beispielsweise SiH₄ und Wasserstoff H₂ und ein Sputtergas, beispielsweise das Edelgas Argon.

Bei dem vorliegenden Beispiel wurden a-Si:H-Schichtsysteme mittels Plasmazersetzung und Gasflußsputtern bei einer Substrattemperatur von 250 °C auf Glassubstraten abgeschieden. In einer ersten Serie wurden dabei schwach bordotierte Siliziumtargets mit einer Borkonzentration n ≈10¹⁵ cm⁻³ eingesetzt. In einer zweiten Serie wurden hochreine Siliziumtargets verwendet. Diese wurden thermisch aufgeheizt auf ca. 250 °C, wodurch eine hinreichende elektrische Leitfähigkeit des Targetmaterials erreicht wurde.

Die Experimente wurden mit einer kleinen, wie oben beschriebenen Laborquelle durchgeführt, wobei der Abstand der Targets 2 cm betrug. Die Tiefe und Länge der Targets betrugen 5 bzw. 10 cm. Zusätzlich zur Zufuhr des Reaktivgases über den Einlaß 4 als Ar/H₂/SiH₄-Gemisch wurden auch SiH₄ und Wasserstoff außerhalb der Gasfluß-Sputterquelle 8 über Einlässe 5 in den Bereich zwischen der Gasfluß-Sputterquelle 8 und dem Substrat 1 zugeführt. Die weiteren Prozeßbedingungen entsprachen typischen, gasflußsputterspezifischen Prozeßbedingungen mit einem Argonpartialdruck von 0,5 mbar, einem Argonfluß von 1,5 slm (Standardliter pro Minute), einem H₂-Fluß zwischen 0 und 100 sccm (Standardkubikzentimeter pro Minute) sowie einem SiH₄-Fluß zwischen 0 und 200 sccm. Die Entladung wurde bei einer konstanten Leistung von 1,0 kW betrieben.

Zur Charakterisierung der Schichteigenschaften wurden Messungen der Dunkel- und Photoleitfähigkeit sowie IR-Absorptionsmessungen durchgeführt. Weiterhin wurde die optische Bandlücke mittels Spektrophotometrie ermittelt.

Im Ergebnis wurde durch die beschriebenen Verfahren unabhängig vom Reaktivgasfluß eine Depositionsrate von 2,1 nm/s erzielt. Die so gesputterten Proben wiesen mit einer Dicke von ca. 750 nm bei optimiertem Reaktivgasfluß (SiH₄) von 75 sccm und Gaseinlaß außerhalb der Quelle eine Dunkelleitfähigkeit von weniger als 10⁻¹⁰ S/cm bzw. von weniger als 10⁻¹³ S/cm bei Verwendung von undotierten Targets auf. Die Messungen der Photoleitfähigkeit zeigten, daß das Verhältnis von Hell- zu Dunkelleitfähigkeit 5 x 10⁵ für die bordotierten Targets bzw. 7 x 10⁵ für die undotierten Silizium-Targets betrug. Die Untersuchung zur IR-Absorption zeigten, daß die Proben nur bei 2000 cm⁻¹ und 640 cm⁻¹ Absorptionsbanden aufwiesen, die den SiH-Schwingungen zugeordnet werden können. Weiterhin wurde eine Bandlücke der Proben zwischen 1,5 und 1,7 eV bestimmt. Das Beweglichkeit-Lebensdauer-Produkt µ x τ betrug sowohl für Löcher als auch für Elektronen > 5 x 10⁻⁹ cm²V⁻¹.

## Patentansprüche

1. Verfahren zur Beschichtung eines Substrats (1) mit amorphen, wasserstoffhaltigen Siliziumschichten (a-Si:H-Schichten, 7),
**dadurch gekennzeichnet, dass** ein Sputtergas sowie ein Reaktivgas, das Si oder eine Si-Verbindung enthält, in eine Hohlkathoden-Gasfluss-Sputterquelle (8) mit einem Target, das Silizium enthält, eingeleitet wird.

2. Verfahren nach dem vorhergehenden Anspruch, **dadurch gekennzeichnet, dass** das Reaktivgas SiH₄ oder Si₂H₆ ist, das gegebenenfalls mit zusätzlichem Reaktivgas mischen kann.

3. Verfahren nach einem der vorhergehenden Ansprüche, **dadurch gekennzeichnet, dass** zwischen die Sputterquelle (8) und das Substrat (1) zusätzliche Reaktivgase eingeleitet werden.

4. Verfahren nach einem der beiden vorhergehenden Ansprüche, **dadurch gekennzeichnet, dass** das Reaktivgas Wasserstoff (H₂) enthält oder daraus besteht.

5. Verfahren nach einem der vorhergehenden Ansprüche, **dadurch gekennzeichnet, dass** als Sputtergas ein Edelgas in die Sputterquelle (8) eingeleitet wird.

6. Verfahren nach dem vorhergehenden Anspruch, **dadurch gekennzeichnet, dass** als Edelgas Argon (Ar) verwendet wird.

7. Verfahren nach einem der vorhergehenden Ansprüche, **dadurch gekennzeichnet, dass** als Kathodenmaterial ein Metall oder Siliziumtargetmaterial (2) verwendet wird, das derart dotiert ist, dass es eine Leitfähigkeit von > 0,01 S/cm aufweist.

8. Verfahren nach einem der vorhergehenden Ansprüche, **dadurch gekennzeichnet, dass** als Targetmaterial (2) bordotiertes Targetmaterial (2) verwendet wird.

9. Verfahren nach dem vorhergehenden Anspruch, **dadurch gekennzeichnet, dass** mit mindestens 10¹⁴ cm⁻³ bordotiertes Targetmaterial (2) verwendet wird.

10. Verfahren nach einem der vorhergehenden Ansprüche, **dadurch gekennzeichnet, dass** als Targetmaterial (2) phosphordotiertes Targetmaterial (2) verwendet wird.

11. Verfahren nach dem vorhergehenden Anspruch, **dadurch gekennzeichnet, dass** mit mindestens 10¹³ cm⁻³ phosphordotiertes Targetmaterial (2) verwendet wird.

12. Verfahren nach einem der vorhergehenden Ansprüche, **dadurch gekennzeichnet, dass** das Reaktivgas zusätzlich Phosphin und/oder Diboran enthält.

13. Verfahren nach einem der vorhergehenden Ansprüche, **dadurch gekennzeichnet, dass** das Targetmaterial (2) thermisch aktiviert wird.

14. Verfahren nach einem der vorhergehenden Ansprüche, **dadurch gekennzeichnet, dass** das Targetmaterial (2) erwärmt wird.

15. Verfahren nach einem der beiden vorhergehenden Ansprüche, **dadurch gekennzeichnet, dass** das Targetmaterial (2) auf über 250 °C erwärmt wird.

16. Verfahren nach einem der vorhergehenden Ansprüche, **dadurch gekennzeichnet, dass** der Arbeitsdruck des Reaktivgases > 10 Pa beträgt.

17. Verwendung eines Verfahrens nach einem der vorhergehenden Ansprüche zur Herstellung von Solarzellen.

## Claims

1. A method for coating a substrate (1) with amorphous, hydrogen-containing silicon layers (a-Si:H layers, 7),
**characterised in that** a sputtering gas and also a reactive gas which contains Si or an Si compound is introduced into a hollow-cathode gas flow sputtering source (8) with a target which contains silicon.

2. A method according to the preceding claim, **characterised in that** the reactive gas is SiH₄ or Si₂H₆, which can optionally mix with additional reactive gas [sic].

3. A method according to one of the preceding claims, **characterised in that** additional reactive gases are introduced between the sputtering source (8) and the substrate (1).

4. A method according to one of the two preceding claims, **characterised in that** the reactive gas contains or consists of hydrogen (H₂).

5. A method according to one of the preceding claims, **characterised in that** a noble gas is introduced into the sputtering source (8) as sputtering gas.

6. A method according to the preceding claim, **characterised in that** argon (Ar) is used as noble gas.

7. A method according to one of the preceding claims, **characterised in that** a metal or silicon target material (2) which is doped such that it has a conductivity of > 0.01 S/cm is used as cathode material.

8. A method according to one of the preceding claims, **characterised in that** boron-doped target material (2) is used as target material (2).

9. A method according to the preceding claim, **characterised in that** target material (2) doped with at least 10¹⁴ cm⁻³ boron is used.

10. A method according to one of the preceding claims, **characterised in that** phosphorus-doped target material (2) is used as target material (2).

11. A method according to the preceding claim, **characterised in that** target material (2) doped with at least 10¹³ cm⁻³ phosphorus is used.

12. A method according to one of the preceding claims, **characterised in that** the reactive gas additionally contains phosphine and/or diborane.

13. A method according to one of the preceding claims, **characterised in that** the target material (2) is thermally activated.

14. A method according to one of the preceding claims, **characterised in that** the target material (2) is heated.

15. A method according to one of the two preceding claims, **characterised in that** the target material (2) is heated to over 250°C.

16. A method according to one of the preceding claims, **characterised in that** the operating pressure of the reactive gas is > 10 Pa.

17. The use of a method according to one of the preceding claims for the production of solar cells.

## Revendications

1. Procédé de revêtement d'un substrat (1) avec des couches de silicium amorphes hydrogénées (couches a-Si : H, 7), **caractérisé en ce qu'**un gaz de pulvérisation ainsi qu'un gaz réactif, qui contient du Si ou un composé Si, est introduit dans une source de pulvérisation par flux gazeux à cathode creuse (8), comportant une cible qui contient du silicium.

2. Procédé selon la revendication précédente, **caractérisé en ce que** le gaz réactif est du SiH₄ ou du Si₂H₆, qui peut le cas échéant se mélanger à du gaz réactif supplémentaire.

3. Procédé selon une des revendications précédentes, **caractérisé en ce que** du gaz réactif supplémentaire est introduit entre la source de pulvérisation (8) et le substrat (1).

4. Procédé selon une des deux revendications précédentes, **caractérisé en ce que** le gaz réactif contient de l'hydrogène (H₂) ou en est constitué.

5. Procédé selon une des revendications précédentes, **caractérisé en ce qu'**on introduit dans la source de pulvérisation (8) en tant que gaz de pulvérisation un gaz inerte.

6. Procédé selon la revendication précédente, **caractérisé en ce que** qu'on utilise en tant que gaz inerte de l'argon (Ar).

7. Procédé selon une des revendications précédentes, **caractérisé en ce qu'**on utilise en tant que matériau cathodique un métal ou un matériau cible en silicium (2) qui est dopé de telle manière qu'il présente une conductivité > 0,01 S/cm.

8. Procédé selon une des revendications précédentes, **caractérisé en ce qu'**on utilise en tant que matériau cible (2) un matériau cible dopé au bore (2).

9. Procédé selon la revendication précédente, **caractérisé en ce qu'**on utilise un matériau cible (2) dopé au bore à au moins 10¹⁴ cm⁻³.

10. Procédé selon une des revendications précédentes, **caractérisé en ce qu'**on utilise en tant que matériau cible (2) un matériau cible dopé au phosphore (2).

11. Procédé selon la revendication précédente, **caractérisé en ce qu'**on utilise un matériau cible (2) dopé au phosphore à au moins 10¹³ cm⁻³.

12. Procédé selon une des revendications précédentes, **caractérisé en ce que** le gaz réactif contient en outre de la phosphine et/ou du diborane.

13. Procédé selon une des revendications précédentes, **caractérisé en ce que** le matériau cible (2) est activé thermiquement.

14. Procédé selon une des revendications précédentes, **caractérisé en ce que** le matériau cible (2) est chauffé.

15. Procédé selon une des deux revendications précédentes, **caractérisé en ce que** le matériau cible (2) est chauffé à une température supérieure à 250 °C.

16. Procédé selon une des revendications précédentes, **caractérisé en ce que** la pression de travail du gaz réactif est > 10 Pa.

17. Utilisation d'un procédé selon une des revendications précédentes pour la fabrication de cellules solaires.
